# EUROPÄISCHE PATENTANMELDUNG

(11) **EP 3 958 306 A1**
(43) Veröffentlichungstag der Anmeldung: **23.02.2022**
(21) Anmeldenummer: 20191654.1
(22) Anmeldetag: 19.08.2020
(51) Int. Cl.: H01L 23/498, H01L 23/057

(54) **LEISTUNGSMODUL MIT MINDESTENS ZWEI AUF EINEM SUBSTRAT KONTAKTIERTEN LEISTUNGSHALBLEITERANORDNUNGEN**

(71) Anmelder: Siemens Aktiengesellschaft, 80333 München (DE)
(72) Erfinder: Kürten, Bernd, 90587 Obermichelbach (DE); Zeyß, Felix, 93059 Regensburg (DE); Botazzoli, Pietro, 91080 Uttenreuth (DE); Endres, Michael, 96110 Schesslitz (DE); Höhne, Silvio, 91301 Forchheim (DE); Gospos, Robert, 91054 Buckenhof (DE); Namyslo, Lutz, 91353 Hausen (DE)

(57) **Zusammenfassung**

Die Erfindung betrifft ein Leistungsmodul (2) mit mindestens zwei auf einem Substrat (4) kontaktierten Leistungshalbleiteranordnungen (6, 8), welche in einem Gehäuse (18) angeordnet sind. Um die Zuverlässigkeit des Leistungsmoduls (2) zu verbessern wird vorgeschlagen, dass die Leistungshalbleiteranordnungen (6, 8) jeweils mindestens ein Halbleiterbauelement (10) aufweisen, wobei das Gehäuse (18) auf gegenüberliegenden Seiten (20, 22) Leistungsanschlüsse (DCp, DCn, AC) aufweist, wobei das Substrat (4) Zuleitungen (24) von den Leistungsanschlüssen (DCp, DCn, AC) zu den Leistungshalbleiteranordnungen (6, 8) aufweist, wobei die Zuleitungen (24, 28, 30) derartig auf dem Substrat (4) angeordnet sind, dass eine symmetrische Stromführung erfolgt.

## Beschreibung

Die Erfindung betrifft ein Leistungsmodul mit mindestens zwei auf einem Substrat kontaktierten Leistungshalbleiteranordnungen, welche in einem Gehäuse angeordnet sind.

Ferner betrifft die Erfindung einen Stromrichter mit mindestens einem derartigen Leistungsmodul.

Darüber hinaus betrifft die Erfindung ein Verfahren zur Herstellung eines derartigen Leistungsmoduls.

In derartigen Stromrichtern werden in der Regel durch ein Gehäuse abgeschlossene Leistungsmodule, beispielweise über eine massive metallische Bodenplatte, auf einen Kühlkörper aufgeschraubt. Unter einem Stromrichter ist beispielsweise ein Gleichrichter, ein Wechselrichter, ein Umrichter oder ein Gleichspannungswandler zu verstehen. Die maximale Ausgangsleistung von derartigen Leistungsmodulen ist insbesondere durch das Gehäuse und die damit verbundenen Außenabmessungen begrenzt. Eine Optimierung einer Anordnung von Halbleiterbauelementen und Strombahnen hinsichtlich des Bauraums kann insbesondere dazu führen, dass beispielsweise Parallelschaltungen von Halbleiterbauelementen elektrisch und thermisch nicht optimal angeordnet werden, wodurch sich eine Verlustleistung der Halbleiterbauelemente unsymmetrisch verteilt und sich die Halbleiterbauelemente unterschiedlich stark aufheizen. Ferner kann es dazu kommen, dass sich benachbart angeordnete Halbleiterbauelemente gegenseitig, insbesondere zu stark, aufheizen, sodass es zu einem Ausfall des Leistungsmoduls kommt.

Vor diesem Hintergrund ist es eine Aufgabe der vorliegenden Erfindung, die Zuverlässigkeit eines Leistungsmoduls zu verbessern.

Die Aufgabe wird erfindungsgemäß gelöst durch ein Leistungsmodul mit mindestens zwei auf einem Substrat kontaktierten Leistungshalbleiteranordnungen, welche in einem Gehäuse angeordnet sind, wobei die Leistungshalbleiteranordnungen jeweils mindestens ein Halbleiterbauelement aufweisen, wobei das Gehäuse auf gegenüberliegenden Seiten Leistungsanschlüsse aufweist, wobei das Substrat Zuleitungen von den Leistungsanschlüssen zu den Leistungshalbleiteranordnungen aufweist, wobei die Zuleitungen derartig auf dem Substrat angeordnet sind, dass eine symmetrische Stromführung erfolgt.

Ferner wird die Aufgabe erfindungsgemäß durch einen Stromrichter mit mindestens einem derartigen Leistungsmodul gelöst.

Darüber hinaus wird die Aufgabe erfindungsgemäß durch ein Verfahren zur Herstellung eines derartigen Leistungsmoduls gelöst, wobei das Substrat, insbesondere stoffschlüssig, mit einer Grundplatte verbunden wird, wobei das Gehäuse flüssigkeitsdicht mit der Grundplatte verbunden wird und wobei eine Verbindung der Leistungsanschlüsse mit dem Substrat hergestellt wird.

Die in Bezug auf das Leistungsmodul nachstehend angeführten Vorteile und bevorzugten Ausgestaltungen lassen sich sinngemäß auf den Stromrichter und das Verfahren übertragen.

Der Erfindung liegt die Überlegung zugrunde, die Zuverlässigkeit eines Leistungsmoduls durch eine symmetrische Ansteuerung von Halbleiterbauelementen zu verbessern. Die Halbleiterbauelemente sind Teil von mindestens zwei auf einem Substrat kontaktierten Leistungshalbleiteranordnungen. Das Substrat weist eine dielektrische Materiallage mit einer, insbesondere beidseitigen, Metallisierung auf. Beispielsweise ist die dielektrische Materiallage 25 µm bis 400 µm, insbesondere 50 µm bis 250 µm, dick und enthält einen keramischen Werkstoff, beispielsweise Aluminiumnitrid oder Aluminiumoxid, oder einen organischen Werkstoff, beispielsweise einem Polyamid. Die Metallisierung ist beispielsweise strukturiert ausgeführt und aus Kupfer hergestellt. Die Halbleiterbauelemente sind beispielsweise als Transistor, insbesondere als Insulated-Gate-Bipolar-Transistor (IGBT), als Metalloxide-Semiconductor-Field-Effect-Transistor (MOSFET) oder als Feldeffekttransistor, oder als Diode ausgeführt. Insbesondere ist zumindest einem Transistor eine antiparalelle Diode zugewiesen.

Die Leistungshalbleiteranordnungen in einem, insbesondere gemeinsamen, Gehäuse angeordnet. Das Gehäuse weist auf gegenüberliegenden Seiten Leistungsanschlüsse auf, wobei das Substrat Zuleitungen von den Leistungsanschlüssen zu den Leistungshalbleiteranordnungen aufweist. Die Zuleitungen sind beispielsweise planar ausgeführt, wobei die planar ausgeführten Zuleitungen Teil der, insbesondere strukturierten Metallisierung des Substrats sind. Eine symmetrische Ansteuerung der Halbleiterbauelemente wird erreicht, indem die Zuleitungen derartig auf dem Substrat angeordnet sind, dass eine symmetrische Stromführung erfolgt. Insbesondere sind Stromwege symmetrisch durch das Leistungsmodul verteilt. Die symmetrische Stromführung führt beispielsweise zu einer gleichmäßigen Aufteilung der Gesamtlast auf parallele Halbleiterbauelemente, wodurch eine Lebensdauer des Leistungsmoduls optimiert wird.

Eine weitere Ausführungsform sieht vor, dass auf zumindest einer ersten Seite des Gehäuses ein erster Leistungsanschluss und ein zweiter Leistungsanschluss angeordnet sind, wobei eine erste Leistungshalbleiteranordnung zwischen einer zweiten Leistungshalbleiteranordnung und den Leistungsanschlüssen auf der ersten Seite des Gehäuses angeordnet ist. Eine derartige Anordnung der Leistungsanschlüsse und der Leistungshalbleiteranordnungen ist platzsparend und ermöglicht einen, insbesondere in Bezug auf eine dynamische Stromaufteilung zwischen parallelgeschalteten Halbleiterbauelementen, symmetrischen Aufbau des Layouts und eine symmetrische Stromführung, wodurch eine Lebensdauer des Leistungsmoduls optimiert wird. Eine weitere Ausführungsform sieht vor, dass auf dem Substrat angeordnete Zuleitungen, welche den zweiten Leistungsanschluss mit der zweiten Leistungshalbleiteranordnung verbinden, beidseitig und symmetrisch an der ersten Leistungshalbleiteranordnung vorbei verlaufend angeordnet sind. Beispielsweise sind die Zuleitungen U-förmig oder V-förmig um die erste Leistungshalbleiteranordnung herum verlaufend angeordnet. Eine derartige symmetrische Anordnung der Zuleitung führt zu einer symmetrischen Stromführung, wodurch, insbesondere parallele, Halbleiterbauelemente gleich ausgesteuert werden. Eine derartige gleichmäßige Aussteuerung führt zu einer Optimierung der Lebensdauer des Leistungsmoduls.

Eine weitere Ausführungsform sieht vor, dass die auf dem Substrat angeordneten Zuleitungen im Wesentlichen achsensymmetrisch zu einer Längsachse verlaufend angeordnet sind. Eine derartige achsensymmetrische Anordnung der Zuleitung führt zu einer gleichmäßigen Aussteuerung, insbesondere paralleler, Halbleiterbauelemente.

Eine weitere Ausführungsform sieht vor, dass das Gehäuse einen, insbesondere parallel zu einer Längsachse verlaufenden, Überstand aufweist, wobei die Zuleitungen zumindest teilweise unterhalb des Überstands angeordnet sind. Insbesondere ist unterhalb des Überstandes des Gehäuses ein Gehäuserahmen zurückgezogen, sodass eine größere Substratfläche, welche beispielsweise für breitere Zuleitungen geeignet ist, zur Verfügung steht. Darüber hinaus sind Halbleiterbauelemente mit einem größeren Abstand voneinander platzierbar, was zu einer Wärmespreizung und einer damit verbundenen verbesserten Entwärmung führt. Durch eine verbesserte Entwärmung wird die Zuverlässigkeit des Leistungsmoduls verbessert und seine Lebensdauer erhöht.

Eine weitere Ausführungsform sieht vor, dass der Überstand Bondpads zur Herstellung einer Bondverbindung mit einer Leistungshalbleiteranordnung aufweist. Durch den Überstand sind kürzere Bondverbindungen mit geringeren parasitären Eigenschaften realisierbar, was zu einer Erhöhung der Effizienz des Leistungsmoduls führt.

Eine weitere Ausführungsform sieht vor, dass der Überstand mindestens 10 % einer Substratoberfläche bedeckt. Durch einen derartigen Überstand weist ein teilweise unterhalb des Überstandes angeordnetes Substrat eine um mindestens 11% vergrößerte Fläche auf, sodass eine höhere Leistungsdichte des Leistungsmoduls erreichbar ist.

Eine weitere Ausführungsform sieht vor, dass die Zuleitungen über Verbindungslaschen mit der zweiten Leistungshalbleiteranordnung verbunden sind. Die Verbindungslaschen sind als gebogenes oder gefalztes Metallblech ausgeführt, welche beispielsweise aus Kupfer hergestellt und stoffschlüssig mit der Metallisierung des Substrats verbunden sind. Insbesondere im Vergleich zu Bonddrähten weisen derartige Verbindungslaschen eine hohe Stromtragfähigkeit und geringe Verluste auf.

Eine weitere Ausführungsform sieht vor, dass der erste Leistungsanschluss und der zweite Leistungsanschluss als DC-Anschlüsse für zumindest eine Halbbrücke ausgeführt sind. Erfahrungsgemäß hat sich eine derartige Beschaltung als besonders vorteilhaft erwiesen.

Eine weitere Ausführungsform sieht vor, dass die Halbleiterbauelemente der ersten Leistungshalbleiteranordnung mit einer ersten Metallisierung des Substrats stoffschlüssig verbunden sind und wobei die Halbleiterbauelemente der zweiten Leistungshalbleiteranordnung mit einer zweiten Metallisierung des Substrats stoffschlüssig verbunden sind und wobei die erste Metallisierung isoliert von der zweiten Metallisierung angeordnet ist. Beispielsweise sind die Halbleiterbauelemente der ersten Leistungshalbleiteranordnung und die Halbleiterbauelemente der zweiten Leistungshalbleiteranordnung jeweils parallelgeschaltet, sodass das Leistungsmodul, welches beispielsweise als Halbbrücke ausgeführt ist, durch einfache Änderungen des Layouts leicht und kostengünstig skalierbar ist.

Eine weitere Ausführungsform sieht vor, dass das Substrat zwei elektrisch voneinander isolierte Substratteile umfasst, wobei eine erste Leistungshalbleiteranordnung auf einem ersten Substratteil und eine zweite Leistungshalbleiteranordnung auf einem zweiten Substratteil angeordnet ist. Eine Trennung der Substrate führt zu einer Wärmespreizung und damit zu einer verbesserten Entwärmung. Durch eine verbesserte Entwärmung wird die Zuverlässigkeit des Leistungsmoduls verbessert und seine Lebensdauer erhöht.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausführungsform eines Leistungsmoduls,
- FIG 2: eine schematische Darstellung einer zweiten Ausführungsform eines Leistungsmoduls,
- FIG 3: eine schematische Darstellung einer dritten Ausführungsform eines Leistungsmoduls und
- FIG 4: einen dreidimensionalen Ausschnitt der dritten Ausführungsform des Leistungsmoduls.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

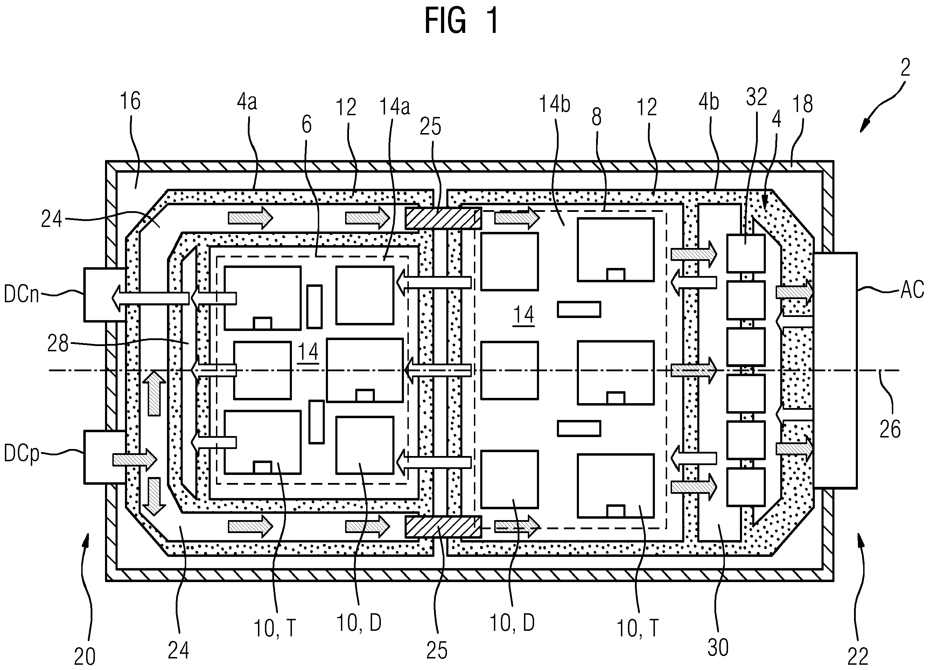

FIG 1 zeigt eine schematische Darstellung einer ersten Ausführungsform eines Leistungsmoduls 2. Das Leistungsmodul 2 weist zwei auf einem Substrat 4 kontaktierte Leistungshalbleiteranordnungen 6, 8 auf, welche Halbleiterbauelemente 10 aufweisen. Die Halbleiterbauelemente 10 sind exemplarisch als Transistoren T, insbesondere als Insulated-Gate-BipolarTransistoren (IGBTs), als Metalloxide-Semiconductor-Field-Effect-Transistoren (MOSFETs) oder als Feldeffekttransistoren, oder als Dioden D ausgeführt. Beispielhaft weisen die Leistungshalbleiteranordnungen 6, 8 jeweils drei Transistoren T und drei Dioden D auf. Insbesondere ist zumindest einem Transistor T eine antiparalelle Diode D zugewiesen. Eine Anzahl der Halbleiterbauelemente 10 ist variabel. Es kann beispielsweise eine erste Leistungshalbleiteranordnungen 6 zwei Transistoren T und zwei, insbesondere antiparalelle, Dioden D aufweisen, welche insbesondere schachbrettartig angeordnet sind, während eine zweite Leistungshalbleiteranordnung 8 zwei Transistoren T und zwei, insbesondere antiparalelle, Dioden D aufweist.

Das Substrat 4 umfasst zwei elektrisch voneinander isolierte Substratteile 4a, 4b, wobei die erste Leistungshalbleiteranordnung 6 auf einem ersten Substratteil 4a und die zweite Leistungshalbleiteranordnung 8 auf einem zweiten Substratteil 4b angeordnet sind. Das Substrat 4 kann auch einstückig ausgebildet sein. Die Substratteile 4a, 4b des Substrats 4 weisen jeweils eine dielektrische Materiallage 12 mit einer Dicke von 25 µm bis 400 µm, insbesondere 50 µm bis 250 µm, auf, die einen keramischen Werkstoff, beispielsweise Aluminiumnitrid oder Aluminiumoxid, oder einen organischen Werkstoff, beispielsweise einem Polyamid enthält. Darüber hinaus weisen die Substratteile 4a, 4b des Substrats 4 jeweils eine, insbesondere strukturierte, beidseitige Metallisierung 14 auf, welche beispielsweise aus Kupfer hergestellt ist. Die Substratteile 4a, 4b des Substrats 4 sind stoffschlüssig mit einer Grundplatte 16 verbunden, welche beispielsweise aus Aluminium oder einer Aluminiumlegierung hergestellt ist. Die stoffschlüssige Verbindung zur Grundplatte 16 wird durch Löten oder Sintern hergestellt.

Das Substrat 4 mit den Leistungshalbleiteranordnungen 6, 8 ist in einem Gehäuse 18 angeordnet, welches auf gegenüberliegenden Seiten 20, 22 des Leistungsmoduls 2 Leistungsanschlüsse DCp, DCn, AC aufweist. Beispielhaft sind auf einer ersten Seite 20 des Gehäuses 18 ein erster Leistungsanschluss DCn und ein zweiter Leistungsanschluss DCp angeordnet, welche als DC-Leistungsanschlüsse ausgeführt sind, wobei die erste Leistungshalbleiteranordnung 6 zwischen der zweiten Leistungshalbleiteranordnung 8 und den Leistungsanschlüssen DCn, DCp auf der ersten Seite 20 des Gehäuses 18 angeordnet ist. Auf einer zweiten Seite 22 des Gehäuses 18 ist ein dritter Leistungsanschluss AC angeordnet, welcher exemplarisch als AC-Leistungsanschluss ausgeführt ist. Beispielhaft ist das Leistungsmodul 2 als eine Halbbrücke ausgeführt.

Auf dem Substrat 4 angeordnete Zuleitungen 24, welche den zweiten Leistungsanschluss DCp mit der zweiten Leistungshalbleiteranordnung 8 verbinden, sind beidseitig und symmetrisch an der ersten Leistungshalbleiteranordnung 6 vorbei verlaufend angeordnet. Ferner sind die auf dem Substrat 4 angeordneten Zuleitungen 24 im Wesentlichen achsensymmetrisch zu einer Längsachse 26 verlaufend ausgeführt, wobei eine symmetrische Stromführung erfolgt. Die symmetrische Stromführung führt zu einer gleichmäßigen Aufteilung der Gesamtlast auf parallele Halbleiterbauelemente 10, wodurch eine Lebensdauer des Leistungsmoduls 2 optimiert wird. Die Zuleitungen 24, welche den zweiten Leistungsanschluss DCp mit der zweiten Leistungshalbleiteranordnung 8 verbinden, sind über Verbindungslaschen 25 mit der zweiten Leistungshalbleiteranordnung (8) verbunden. Derartige Verbindungslaschen 25 sind beispielsweise aus Kupfer hergestellt und weisen, insbesondere im Vergleich zu Bonddrähten, eine hohe Stromtragfähigkeit und geringe Verluste auf.

Ebenso ist eine Zuleitung 26, welche den ersten Leistungsanschluss DCn mit der ersten Leistungshalbleiteranordnung 6 verbindet, derartig mittig zwischen den Zuleitungen 24, welche den zweiten Leistungsanschluss DCp mit der zweiten Leistungshalbleiteranordnung 8 verbinden, auf dem Substrat 4 angeordnet, dass eine symmetrische Stromführung erfolgt, was sich positiv auf die Lebensdauer des Leistungsmoduls 2 auswirkt. Insbesondere ist die Zuleitung 28, welche den ersten Leistungsanschluss DCn mit der ersten Leistungshalbleiteranordnung 6 verbindet, ebenfalls im Wesentlichen achsensymmetrisch zur Längsachse 26 verlaufend ausgeführt. Darüber hinaus ist die Zuleitung 30, welche den dritten Leistungsanschluss AC mit der zweiten Leistungshalbleiteranordnung 8 verbindet, im Wesentlichen achsensymmetrisch zur Längsachse 26 verlaufend ausgeführt, wobei eine symmetrische Stromführung erfolgt. Die Zuleitung 30, welche den dritten Leistungsanschluss AC mit der zweiten Leistungshalbleiteranordnung 8 verbindet, weist Shunts 32, welche beispielsweise zur Strommessung konfiguriert sind, auf, wobei die Shunts 32 ebenso im Wesentlichen achsensymmetrisch zur Längsachse 26 angeordnet sind.

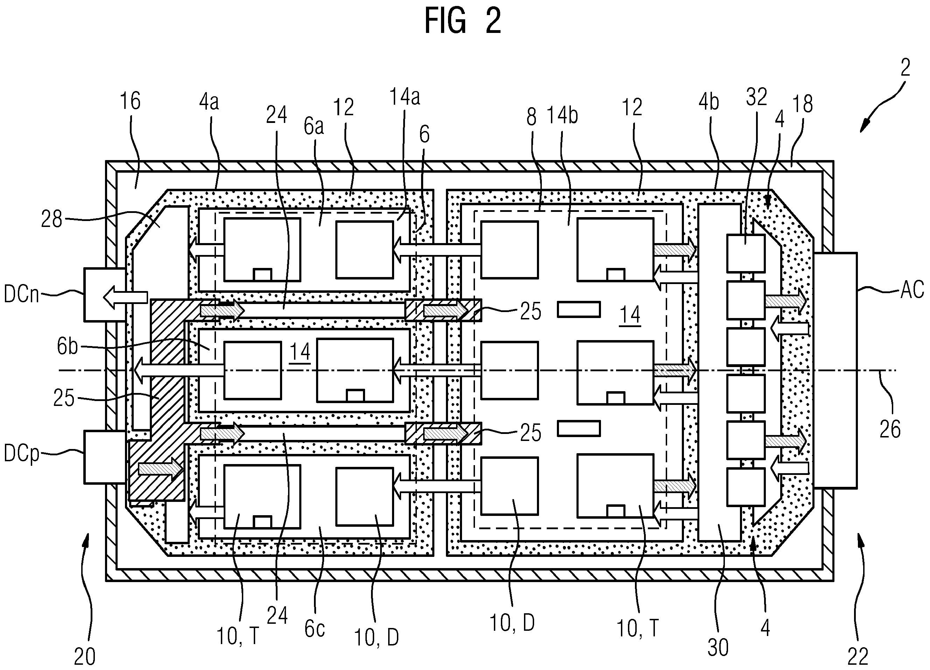

FIG 2 zeigt eine schematische Darstellung einer zweiten Ausführungsform eines Leistungsmoduls 2, wobei die erste Leistungshalbleiteranordnung 6 in drei im Wesentlichen gleich große, parallel verlaufende und achsensymmetrisch zur Längsachse 26 angeordnete Teilanordnungen 6a, 6b, 6c aufgeteilt ist. Beispielsweise weisen die Teilanordnungen 6a, 6b, 6c jeweils einen Transistor T mit einer antiparallelen Diode D auf. Die Zuleitungen 24, welche den zweiten Leistungsanschluss DCp mit der zweiten Leistungshalbleiteranordnung 8 verbinden, sind achsensymmetrisch zur Längsachse 26 zwischen den Teilanordnungen 6a, 6b, 6c angeordnet, wobei eine symmetrische Stromführung erfolgt, wodurch sich eine optimale Wärmespreizung ergibt. Die weitere Ausführung des Leistungsmoduls 2 in FIG 2 entspricht der Ausführung in FIG 1.

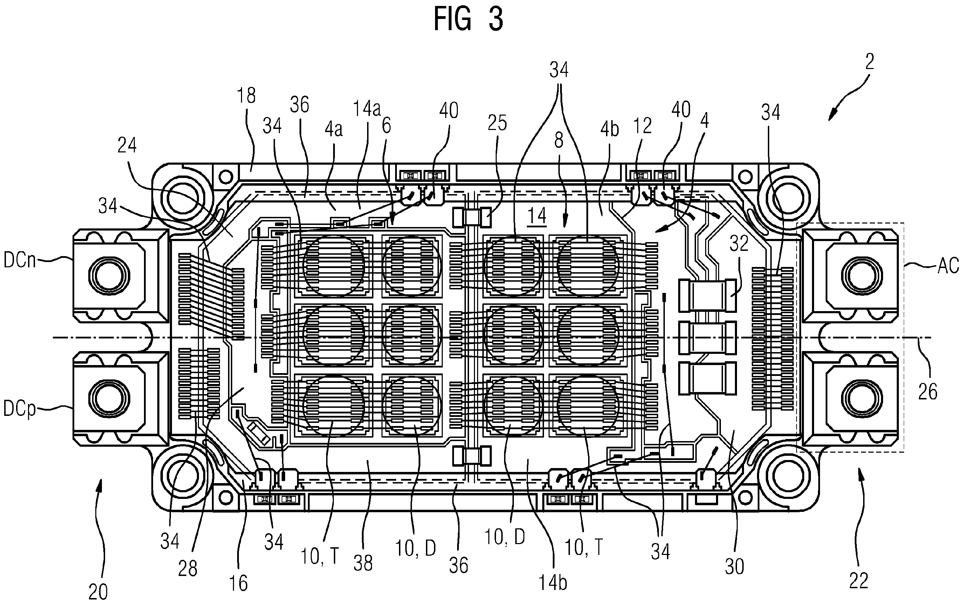

FIG 3 zeigt eine schematische Darstellung einer dritten Ausführungsform eines Leistungsmoduls 2, wobei Bondverbindungen 34 zu den Halbleiterbauelementen 10 und Zuleitungen 24, 28, 30 gezeigt sind. Die Halbleiterbauelemente 10 der Leistungshalbleiteranordnungen 6, 8 sind derartig auf dem Substrat 4 angeordnet, dass stromtragende Bondverbindungen 34 im Wesentlichen parallel zur Längsachse 26 verlaufen.

Das Gehäuse 18 des Leistungsmoduls 2 weist im Wesentlichen parallel zur Längsachse 26 verlaufende, Überstände 36 auf, wobei die Zuleitungen 24 zumindest teilweise unterhalb der Überstände 36 angeordnet sind. Beispielsweise bedecken die Überstände 36 mindestens 10 % einer Substratoberfläche 38. Ferner weisen die Überstände 36 Bondpads 40 zur Herstellung einer Bondverbindung mit einer Leistungshalbleiteranordnung 6, 8 auf. Die weitere Ausführung des Leistungsmoduls 2 in FIG 3 entspricht der Ausführung in FIG 1.

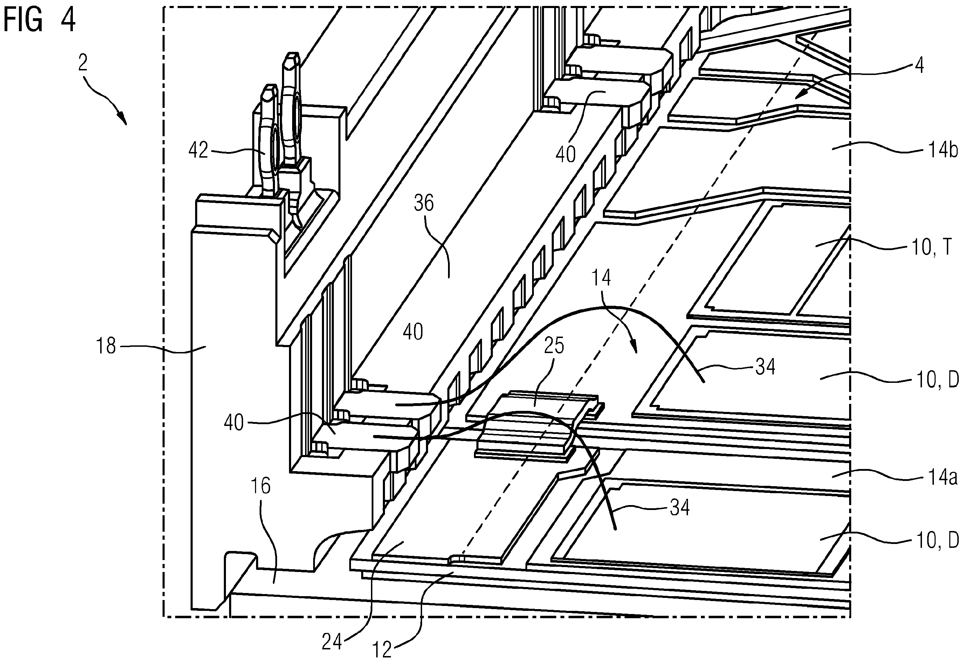

FIG 4 zeigt einen dreidimensionalen Ausschnitt der dritten Ausführungsform des Leistungsmoduls 2. Die Zuleitung 24 befindet sich teilweise unterhalb des Überstands 36 des Gehäuses 18, da die Bondflächen des Gehäuses 18 nicht vollständig mit Gehäusematerial unterfüttert sind. Durch die Überstände wird Bauraum gewonnen, sodass die Halbleiterbauelemente 10 weiter auseinander platzierbar sind, wodurch es zu einer verbesserten Entwärmung durch Wärmespreizung kommt. Ferner sind durch den zusätzlichen Bauraum die Zuleitungen 24 breiter auslegbar, was zu einer höheren Stromtragfähigkeit führt. Die Bondpads 40, über welche Bondverbindungen 34 zu den Halbleiterbauelementen 10 hergestellt werden, sind mit im Gehäuse 18 aufgenommenden Pins 42, insbesondere Pressfit-Pins oder Lötpins, verbunden. Weitere Bondverbindungen 34 sind aus Gründen der Übersichtlichkeit in FIG 4 nicht dargestellt. Die weitere Ausführung des Leistungsmoduls 2 in FIG 4 entspricht der Ausführung in FIG 3.

Zusammenfassend betrifft die Erfindung ein Leistungsmodul 2 mit mindestens zwei auf einem Substrat 4 kontaktierten Leistungshalbleiteranordnungen 6, 8, welche in einem Gehäuse 18 angeordnet sind. Um die Zuverlässigkeit des Leistungsmoduls 2 zu verbessern wird vorgeschlagen, dass die Leistungshalbleiteranordnungen 6, 8 jeweils mindestens ein Halbleiterbauelement 10 aufweisen, wobei das Gehäuse 18 auf gegenüberliegenden Seiten 20, 22 Leistungsanschlüsse DCp, DCn, AC aufweist, wobei das Substrat 4 Zuleitungen 24 von den Leistungsanschlüssen DCp, DCn, AC zu den Leistungshalbleiteranordnungen 6, 8 aufweist, wobei die Zuleitungen 24, 28, 30 derartig auf dem Substrat 4 angeordnet sind, dass eine symmetrische Stromführung erfolgt.

## Patentansprüche

1. Leistungsmodul (2) mit mindestens zwei auf einem Substrat (4) kontaktierten Leistungshalbleiteranordnungen (6, 8),
welche in einem Gehäuse (18) angeordnet sind,
wobei die Leistungshalbleiteranordnungen (6, 8) jeweils mindestens ein Halbleiterbauelement (10) aufweisen,
wobei das Gehäuse (18) auf gegenüberliegenden Seiten (20, 22)
Leistungsanschlüsse (DCp, DCn, AC) aufweist, wobei das Substrat (4) Zuleitungen (24) von den Leistungsanschlüssen (DCp, DCn, AC) zu den Leistungshalbleiteranordnungen (6, 8) aufweist,
wobei die Zuleitungen (24, 28, 30) derartig auf dem Substrat (4) angeordnet sind, dass eine symmetrische Stromführung erfolgt.

2. Leistungsmodul (2) nach Anspruch 1,
wobei auf zumindest einer ersten Seite (20) des Gehäuses (18) ein erster Leistungsanschluss (DCn) und ein zweiter Leistungsanschluss (DCp) angeordnet sind,
wobei eine erste Leistungshalbleiteranordnung (6) zwischen einer zweiten Leistungshalbleiteranordnung (8) und den Leistungsanschlüssen (DCp, DCn) auf der ersten Seite (20) des Gehäuses (18) angeordnet ist.

3. Leistungsmodul (2) nach Anspruch 2,
wobei auf dem Substrat (4) angeordnete Zuleitungen (24), welche den zweiten Leistungsanschluss (DCp) mit der zweiten Leistungshalbleiteranordnung (8) verbinden, beidseitig und symmetrisch an der ersten Leistungshalbleiteranordnung (6) vorbei verlaufend angeordnet sind.

4. Leistungsmodul (2) nach Anspruch 3,
wobei die auf dem Substrat (4) angeordneten Zuleitungen (24) im Wesentlichen achsensymmetrisch zu einer Längsachse (26) verlaufend angeordnet sind.

5. Leistungsmodul (2) nach einem der Ansprüche 3 oder 4,
wobei das Gehäuse (18) einen, insbesondere parallel zu einer Längsachse (26) verlaufenden, Überstand (36) aufweist,
wobei die Zuleitungen (24) zumindest teilweise unterhalb des Überstands (36) angeordnet sind.

6. Leistungsmodul (2) nach Anspruch 5,
wobei der Überstand (36) Bondpads (40) zur Herstellung einer Bondverbindung (34) mit einer Leistungshalbleiteranordnung (6, 8) aufweist.

7. Leistungsmodul (2) nach einem der Ansprüche 5 oder 6, wobei der Überstand (36) mindestens 10 % einer Substratoberfläche (38) bedeckt.

8. Leistungsmodul (2) nach einem der Ansprüche 3 bis 7, wobei die Zuleitungen (24) über Verbindungslaschen (25) mit der zweiten Leistungshalbleiteranordnung (8) verbunden sind.

9. Leistungsmodul (2) nach einem der Ansprüche 2 bis 8, wobei der erste Leistungsanschluss (DCn) und der zweite Leistungsanschluss (DCp) als DC-Anschlüsse für zumindest eine Halbbrücke ausgeführt sind.

10. Leistungsmodul (2) nach einem der vorherigen Ansprüche, wobei die Halbleiterbauelemente (10) der ersten Leistungshalbleiteranordnung (6) mit einer ersten Metallisierung (14a) des Substrats (4) stoffschlüssig verbunden sind und
wobei die Halbleiterbauelemente (10) der zweiten Leistungshalbleiteranordnung (8) mit einer zweiten Metallisierung (14b) des Substrats (4) stoffschlüssig verbunden sind und
wobei die erste Metallisierung (14a) isoliert von der zweiten Metallisierung (14b) angeordnet ist.

11. Leistungsmodul (2) nach einem der vorherigen Ansprüche, wobei das Substrat (4) zwei elektrisch voneinander isolierte Substratteile (4a, 4b) umfasst,
wobei eine erste Leistungshalbleiteranordnung (6) auf einem ersten Substratteil (4a) und eine zweite Leistungshalbleiteranordnung (8) auf einem zweiten Substratteil (4b) angeordnet ist.

12. Stromrichter mit mindestens einem Leistungsmodul (2) nach einem der Ansprüche 1 bis 11.

13. Verfahren zur Herstellung eines Leistungsmoduls (2) nach einem der Ansprüche 1 bis 11,
wobei das Substrat (4), insbesondere stoffschlüssig, mit einer Grundplatte (16) verbunden wird,
wobei das Gehäuse (18) flüssigkeitsdicht mit der Grundplatte (16) verbunden wird und
wobei eine Verbindung der Leistungsanschlüsse (DCp, DCn, AC) mit dem Substrat (4) hergestellt wird.

14. Verfahren nach Anspruch 13,
wobei die Leistungsanschlüsse (DCp, DCn, AC) jeweils über Bondverbindungen (34) mit dem Substrat (4) verbunden werden.

15. Verfahren nach einem der Ansprüche 13 oder 14,
wobei das Gehäuse (18) zumindest teilweise mit einer Vergussmasse gefüllt wird.
